(19) Europäisches Patentamt
European Patent Office
Office européen des brevets

(11) EP 4 674 858 A1

(12) EUROPEAN PATENT APPLICATION
published in accordance with Art. 153(4) EPC

(43) Date of publication:
07.01.2026 Bulletin 2026/02

(21) Application number: 24764028.7

(22) Date of filing: 01.03.2024

(51) International Patent Classification (IPC):
*C07F 7/22* (2006.01) *C01G 19/00* (2006.01)
*G03F 7/004* (2006.01)

(52) Cooperative Patent Classification (CPC):
**C01G 19/00; C07F 7/22; G03F 7/004**

(86) International application number:
**PCT/JP2024/007675**

(87) International publication number:
**WO 2024/181551 (06.09.2024 Gazette 2024/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **02.03.2023 JP 2023031562**
**12.10.2023 JP 2023176859**

(71) Applicants:
- **Mitsubishi Chemical Corporation**
  **Tokyo 100-8251 (JP)**
- **Gelest, Inc.**
  **Morrisville, PA 19067 (US)**

(72) Inventors:
- **HAYASHI, Kouichi**
  **Tokyo 100-8251 (JP)**
- **HIOKI, Yuta**
  **Tokyo 100-8251 (JP)**

(74) Representative: **Vossius & Partner**
**Patentanwälte Rechtsanwälte mbB**
**Siebertstrasse 3**
**81675 München (DE)**

(54) **HIGH PURITY TIN COMPOUND, STORAGE METHOD AND PRODUCTION METHOD FOR SAME, AND TIN HYDROLYSIS PRODUCT, TIN HYDROLYSIS PRODUCT SOLUTION AND TIN HYDROLYSIS PRODUCT THIN FILM EACH USING SAME**

(57) A high-purity tin compound that can maintain high purity for a long time, in particular, in which decomposition of a triaminotin compound is suppressed and high purity of the triaminotin compound is maintained, is provided as follows. The tin compound contains 95 mol% or more of a triaminotin compound having formula (1) in terms of tin atoms, and 0.001 to 0.5 mol% of a tetraaminotin compound having formula (2) in terms of tin atoms:

$RSn(NR'_2)_3$ (1)

$Sn(NR'_2)_4$ (2)

wherein R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other; two R's on the same nitrogen atom may be bonded to each other to form a 3- to 7-membered ring containing nitrogen.



Processed by Luminess, 75001 PARIS (FR)

## Description

### TECHNICAL FIELD

The present disclosure relates to a high-purity tin compound. The present disclosure also relates to methods for storing and producing a high-purity tin compound, and a tin hydrolysate, a tin hydrolysate solution, and a tin hydrolysate thin film using the same.

### BACKGROUND ART

In recent years, there has been a need to handle a greater amount of information at higher speeds with higher precision against the background of a paradigm shift to an advanced information society. Technologies related to semiconductor devices such as integrated circuits using semiconductors have been advancing noticeably day by day.
The evolution of semiconductor design has necessitated the formation of ever finer features on semiconductor substrate materials, with individual features being approximately 22 nm or less, and in some cases less than 10 nm. One of challenges in fabrication of devices with such fine features is the ability to reliably and reproducibly form photolithography masks having sufficient resolution. Achieving feature sizes smaller than the wavelength of light requires the use of complex techniques for achieving high resolution, such as multi-patterning. Therefore, the development of photolithography techniques using shorter wavelength light, such as extreme ultraviolet radiation (EUV) with a wavelength of 10 nm to 15 nm (e.g., 13.5 nm), is of great importance.
Conventional organic chemically amplified resists (CARs) have potential drawbacks when used in EUV lithography because they have low adsorption coefficients in the EUV region and can cause blur in diffusion of photoactivated chemical species or line edge roughness. Thus, there remains a need for improved EUV photoresist materials having properties such as smaller thickness, improved absorbance, and improved etch resistance.
For this reason, liquid chemical vapor deposition (CVD) materials such as organotin have recently begun to be used as resists, especially for EUV applications. Extremely high-purity materials are required to ensure high quality in film formation. Therefore, hydrocarbyl tin compounds such as a triaminotin compound having one hydrocarbon group, which are preferably used among organotins, are used as CVD materials after impurities such as water, residual solvents used in synthesis, and metal impurities are removed by distillation or the like (PTL 1).
In PTL 2, a high-purity hydrocarbyl tin compound is produced by devising a manufacturing process.

### RELATED ART DOCUMENT

### PATENT DOCUMENT

PTL 1: JP-A-2020-122959
PTL 2: WO-A-2022/165381

### SUMMARY

### PROBLEMS TO BE SOLVED BY THE DISCLOSURE

However, it has been difficult to maintain the high purity of hydrocarbyl tin compounds for a long time after their production because of their high reactivity and decomposability due to the low binding energy between carbon, nitrogen, and oxygen, which are Period 2 elements, and tin, which is a Period 5 element.
In such a circumstance, the present disclosure provides a high-purity tin compound that can maintain high purity for a long time, in particular, in which decomposition of a triaminotin compound is suppressed and high purity of the triaminotin compound is maintained.

### MEANS FOR SOLVING THE PROBLEMS

In order to solve the above problem, the inventors of the present disclosure have conducted elaborate studies and found that the above object is achieved in a triaminotin compound having one hydrocarbon group (which hereinafter may be simply referred to as "triaminotin compound"), specifically, a triaminotin compound having formula (1), by intentionally mixing a particular trace amount of a tetraaminotin compound having formula (2).
Specifically, the present disclosure has the following aspects.

[1] A tin compound containing 95 mol% or more of a triaminotin compound having formula (1) in terms of tin atoms, and 0.001 to 0.5 mol% of a tetraaminotin compound having formula (2) in terms of tin atoms:

$RSn(NR'_2)_3$ (1)

$Sn(NR'_2)_4$ (2)

wherein R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.

[2] The tin compound according to [1], wherein the tin compound contains 97 mol% or more of the triaminotin compound having formula (1) in terms of tin atoms.

[3] The tin compound according to [1] or [2], wherein the tin compound contains 0.5 mol% or less of a diaminotin compound having formula (3) in terms of tin atoms:

$R_2Sn(NR'_2)_2$ (3)

wherein R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.

[4] The tin compound according to any one of [1] to [3], wherein the tin compound contains 0.01 to 0.5 mol% of the tetraaminotin compound having formula (2) in terms of tin atoms.

[5] A tin compound containing 95 mol% or more of a triaminotin compound having formula (1) in terms of tin atoms, wherein the triaminotin compound having formula (1) has a decomposition rate of 0.85 mol% or less after being held at 140°C for 5 hours under a nitrogen atmosphere:

$RSn(NR'_2)_3$ (1)

wherein R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.

[6] The tin compound according to [5], wherein the tin compound contains 97 to 99.9 mol% of the triaminotin compound having formula (1) in terms of tin atoms.

[7] The tin compound according to any one of [1] to [6], wherein the tin compound further contains 0.001 to 1.0 mol% of a compound having formula (7) in terms of tin atoms:

$RSn(NR')_2(N(R')CHNR'_2)$ (7)

wherein R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.

[8] The tin compound according to [7], wherein the tin compound contains 0.001 mol% or more of each of the compound having formula (2) and the compound having formula (7), and a total content of the compound having formula (2) and the compound having formula (7) is 0.001 to 1.0 mol% in terms of tin atoms.

[9] The tin compound according to any one of [1] to [8], wherein the tin compound further contains 0.001 to 1.0 mol% of a compound having formula (9) in terms of tin atoms:

$RSn(NR')_2(OR)$ (9)

wherein R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.

[10] A tin compound containing 95 mol% or more of a triaminotin compound having formula (1) in terms of tin atoms,

0.001 to 0.5 mol% of a tetraaminotin compound having formula (2) in terms of tin atoms, 0.5 mol% or less of a diaminotin compound having formula (3) in terms of tin atoms, 0.001 to 1.0 mol% of a compound having formula (7) in terms of tin atoms, and 0.001 to 1.0 mol% of a compound having formula (9) in terms of tin atoms:

$$RSn(NR'_2)_3 \qquad (1)$$

$$Sn(NR'_2)_4 \qquad (2)$$

$$R_2Sn(NR'_2)_2 \qquad (3)$$

$$RSn(NR')_2(N(R')CHNR'_2) \qquad (7)$$

$$RSn(NR')_2(OR) \qquad (9)$$

wherein

in formula (1) and (2), R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen;
in formula (3), R is a hydrocarbon group having 1 to 30 carbon atoms and optionally substituted with halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen;
in formula (7), R is a hydrocarbon group having 1 to 30 carbon atoms and optionally substituted with halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen; and
in formula (9), R is a hydrocarbon group having 1 to 30 carbon atoms and optionally substituted with halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.

[11] The tin compound according to any one of [1] to [10], wherein the tin compound further contains a solvent.
[12] A method for storing a tin compound, wherein the tin compound according to any one of [1] to [11] is stored in a sealed container under a nitrogen atmosphere.
[13] The method for storing a tin compound according to [12], wherein the tin compound is stored for a period of 3 days to 1 year.
[14] The method for storing a tin compound according to [12] or [13], wherein the tin compound is stored at a temperature of -10°C or higher and 40°C or lower.
[15] A method for producing a tin compound according to any one of [1] to [10], the method including a step of obtaining a target tin compound as a fraction by distilling a crude tin compound.
[16] A method for producing a tin compound according to any one of [1] to [10], the method including a step of obtaining a target tin compound by adding the tetraaminotin compound having formula (2) to a tin compound comprising the triaminotin compound having formula (1) which does not contain the tetraaminotin compound having formula (2).
[17] The method for producing a tin compound according to [15] or [16], wherein a first fraction is included in a fraction in distillation of a crude tin compound.
[18] A tin hydrolysate of the tin compound according to any one of [1] to [11], wherein the tin hydrolysate has formula (10):

$$RSnO_{(3/2-x/2)}(OH)_x \qquad (10)$$

wherein x satisfies $0 < x \leq 3$.
[19] A tin hydrolysate solution containing the tin hydrolysate according to [18] and an organic solvent.
[20] A tin hydrolysate thin film containing the tin hydrolysate according to [18].

EFFECTS OF THE DISCLOSURE

The tin compound containing a triaminotin compound according to the present disclosure contains a certain amount of a tetraaminotin compound, whereby the decomposition of the triaminotin compound can be suppressed and the high purity of the triaminotin compound can be maintained. Furthermore, since a particular tin compound is contained, this effect can be achieved more effectively.

BRIEF DESCRIPTION OF THE DRAWINGS

FIG. 1 illustrates ESI-mass spectra of Example 4, in which FIG. 1(a) is an overall spectrum, FIG. 1(b) is a spectrum of a divalent ion group, and FIG. 1(c) is a spectrum of a monovalent ion group.
FIG. 2 illustrates ESI-mass spectra of Comparative Example 4, in which FIG. 2(a) is an overall spectrum, FIG. 2(b) is a spectrum of a divalent ion group, and FIG. 2(c) is a spectrum of a monovalent ion group.
FIG. 3 illustrates an XRD spectrum of Example 4.
FIG. 4 illustrates an XRD spectrum of Comparative Example 4.

DESCRIPTION OF THE PREFERRED EMBODIMENTS

The present disclosure will be described below based on exemplary embodiments for carrying out the present disclosure. However, the present disclosure is not limited to the exemplary embodiments described below.
In the present disclosure, the expression "X to Y" (X and Y are each a given number) means "X or more and Y or less" and also includes the meaning of "preferably more than X" or "preferably less than Y", unless otherwise specified.
The expression "X or more" (X is a given number) or "Y or less" (Y is a given number) includes the meaning of "preferably more than X" or "preferably less than Y".
Furthermore, "X and/or Y (X and Y are each a given configuration)" means at least one of X and Y and can mean the following three meanings: "X only", "Y only", and "X and Y".
For a numerical range described herein in steps, the upper or lower limit of the numerical range in one step can be arbitrarily combined with the upper or lower limit of the numerical range in another step. The upper limit or lower limit of a numerical range described herein may be replaced by values shown in the examples.
As used herein "main component" means a component that has a significant effect on the properties of an object, and the content of the component is usually 50% by mass or more in the object, preferably 55% by mass or more, more preferably 60% by mass or more, even more preferably 70% by mass or more, and may be 100% by mass.
A tin compound containing a triaminotin compound according to one embodiment of the present disclosure (which hereinafter may be referred to as "the present tin compound") will be described in detail below.

<Triaminotin Compound (1)>

The triaminotin compound (1) contained in the present tin compound is defined as follows. The triaminotin compound (1) is a compound in which one hydrocarbon group and three amino groups substituted with hydrocarbon groups are bonded to tetravalent tin. Specifically, the triaminotin compound (1) is represented by the following formula (1):

$$RSn(NR'_2)_3 \qquad (1)$$

wherein R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.
The carbon number of the substituent R is typically 1 to 30, preferably 2 to 10, and more preferably 3 to 6, in consideration of the ease of removal and vaporization during EUV exposure.
Preferred specific examples of the substituent R include alkyl groups such as methyl, ethyl, propyl, isopropyl, butyl, isobutyl, sec-butyl, t-butyl, pentyl, hexyl, cyclopentyl, and cyclohexyl groups, aromatic hydrocarbon groups such as phenyl, tolyl, and benzyl groups, alkenyl groups such as vinyl, 1-propenyl, allyl, and 3-butenyl groups, and alkyl groups substituted with halogen atoms, such as 2-fluoroethyl and 2-iodoethyl groups.
Since the amino group is hydrolyzed and removed during resist formation, the carbon number of R' is preferably 1 to 4 and further preferably 1 or 2, in consideration of the ease of removal and vaporization. In particular, R' is preferably an alkyl group. R's are preferably identical.

Other specific examples of R include, for example, the following structures. $R^a$ ($R^A$), $R^b$ ($R^B$), and $R^c$ ($R^C$) in the following chemical formulae are each an organic group having 1 to 10 carbon atoms which is optionally substituted with a heteroatom such as a halogen, oxygen, or nitrogen atom. The substituent A on the aromatic ring is a halogen atom or an organic substituent having 1 to 10 carbon atoms which may contain an oxygen or nitrogen atom.

R =

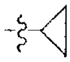 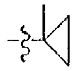 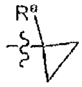

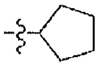 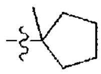 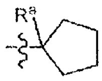 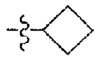 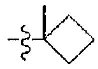 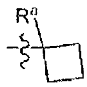

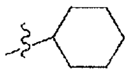 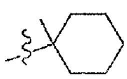 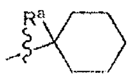 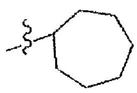 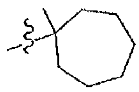 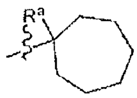

R =

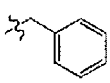 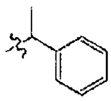 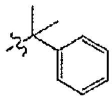 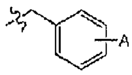 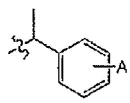 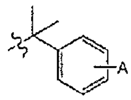

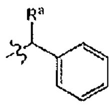 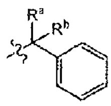 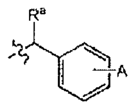 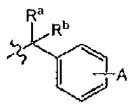

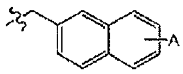 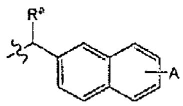 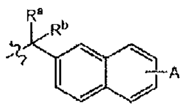

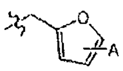 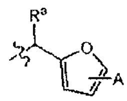 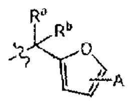

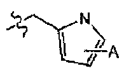 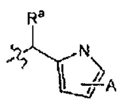 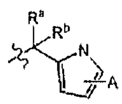

R =

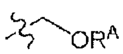 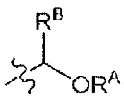 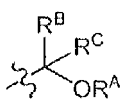 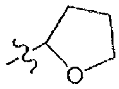 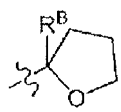

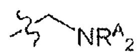
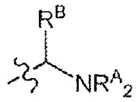
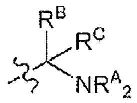
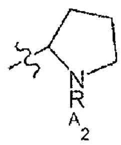
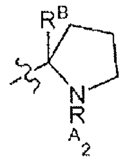

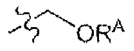
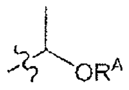
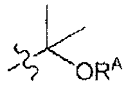
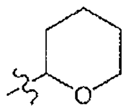
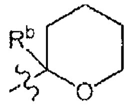

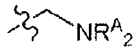
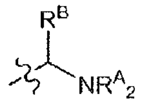
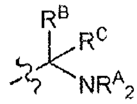
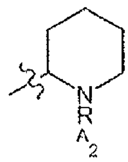
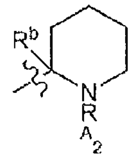

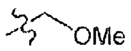
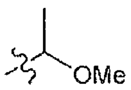
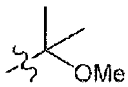

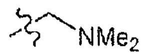
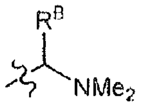
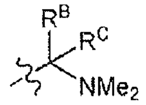

Preferred specific examples of the substituent R' include methyl, ethyl, propyl, isopropyl, butyl, isobutyl, sec-butyl, and t-butyl groups. An example of $NR'_2$ is a 1-pyrrolidinyl group in a form in which two ethyl groups on nitrogen are bonded together to form a 5-membered ring.

Such a triaminotin compound (1) is in a liquid state at normal temperature and normal pressure (23°C, 1 atm).

The content of triaminotin compound (1) in the present tin compound is 95 mol% or more in terms of tin atoms. Furthermore, the higher the ratio of triaminotin, the higher the purity of the resist material and the better the performance of the resist. Thus, the content of triaminotin compound (1) is further preferably 97 mol% or more, and particularly preferably 99 mol% or more. If the purity of triaminotin compound (1) contained is low, the triaminotin compound (1) may react with another tin compound, or a decomposition reaction such as disproportionation of triaminotin compound (1) may be accelerated, so that the decomposition suppressing effect may be insufficient. Thus, preferred purity particularly for stable storage is 95 mol% or more, preferably 97 mol% or more, even more preferably 98 mol% or more, and particularly preferably 99 mol% or more.

The upper limit of purity is preferably 99.999% or less, more preferably 99.9% or less, and even more preferably 99.5% or less. If the ratio of the triaminotin compound (1) is too high, the ratio of the tetraaminotin compound (2) will be too low. This tends to limit the decomposition suppressing effect.

As used herein "mol% in terms of tin atoms" is the ratio of tin atoms in a target compound out of the number of tin atoms in all compounds having tin atoms (including compounds that are not identified). In practice, the ratio of tin atoms is calculated by $^{119}$Sn-NMR, in which the sum of the integrals of all observed peaks is the denominator and the integral of the peak of the target compound is the numerator.

According to this calculation method, only compounds having tin atoms are subject to the calculation. For example, even if additives and solvents are added according to each application after triaminotin compound (1) is produced, the resulting compound falls within the range of the present tin compound as long as triaminotin compound (1) and tetraaminotin compound (2) have a predetermined composition ratio.

When performing analysis using $^{119}$Sn-NMR, the tin compounds are analyzed without dilution in order to improve sensitivity, using conditions including a large number of accumulations (1000 or more, preferably 10000 or more), a sufficient relaxation time (1 second or more), and inverse gated decoupling. As a result, the detection limit for tin compounds can reach 0.01 mol% by using these methods. In addition, if the sensitivity of the measured peak is still insufficient, high-sensitivity NMR (e.g., 600 MHz NMR using a cryoprobe) can be used to further increase detection sensitivity, allowing detection of 0.001 mol%. On the other hand, tetraaminotin compound (2) may have a broad peak and have a detection limit larger than that of normal tin compounds. In such a case, the number of accumulations or the like may be increased.

<Tetraaminotin Compound (2)>

In the present embodiment, the decomposition of triaminotin compound (1) may be suppressed and the high purity of triaminotin compound (1) may be maintained by intentionally mixing tetraaminotin compound (2) with triaminotin compound (1).

The tetraaminotin compound (2), which is another essential component of the present tin compound, is a compound in which four amino groups are bonded to tetravalent tin. Specifically, tetraaminotin compound (2) has formula (2):

$$Sn(NR'_2)_4 \qquad (2)$$

wherein R's are each a hydrocarbon group having 1 to 10 carbon atoms and may be identical or different from each other, wherein two R's on the same nitrogen atom may be bonded to each other to form a 3- to 7-membered ring containing nitrogen.

The carbon number of the substituent R' is preferably 1 to 4, and even more preferably 1 or 2, in consideration of the ease of removal and vaporization during hydrolysis. In particular, R' is preferably an alkyl group. R's are preferably identical.

Preferred specific examples of the substituent R' include methyl, ethyl, propyl, isopropyl, butyl, isobutyl, s-butyl, and t-butyl groups. An example of $NR'_2$ is a 1-pyrrolidinyl group in a form in which two ethyl groups on nitrogen are bonded together to form a 5-membered ring.

The lower limit of the content of the tetraaminotin compound (2) in the present tin compound is preferably 0.001 mol% or more, more preferably 0.005 mol% or more, and especially preferably 0.01 mol% or more in terms of tin atoms. The upper limit is preferably 0.5 mol% or less, more preferably 0.3 mol% or less, particularly preferably 0.1 mol% or less, especially preferably 0.05 mol% or less, and even more preferably 0.03 mol% or less. If the content of the tetraaminotin compound (2) is higher than the above upper limit or lower than the above lower limit, the effect of suppressing the decomposition of the triaminotin compound (1) may be reduced. If the content of the tetraaminotin compound (2) is excessively higher than the above upper limit, the purity of the triaminotin compound (1) is reduced, resulting in insufficient purity as a resist material. As a result, resist performance may be reduced. It is not clear what causes the effect of tetraaminotin compound (2) suppressing the decomposition of triaminotin compound (1), but it is believed that, for example, tetraaminotin compound (2), which is a compound having four $NR'_2$ structures, prevents side reactions such as disproportionation due to removal of the $NR'_2$ structure of triaminotin compound (1) and provides a stabilizing effect. It is also believed that tetraaminotin compound (2) having a large number of highly reactive $NR'_2$ structures serves to prevent decomposition due to reactions with other impurities.

On the other hand, the inclusion of a particular amount of a particular tin compound in the present tin compound (in addition to tin compounds (1) and (2) may promote the effect of inclusion of tetraaminotin compound (2) in the present tin compound. Such a particular tin compound will be described below.

<Diamino Tin Compound (3)>

The present tin compound preferably contains a dihydrocarbyl diaminotin compound (which hereinafter may be simply referred to as "diaminotin compound") (3), which is known as a byproduct during production of the triaminotin compound (1). The diaminotin compound (3) is a compound in which two hydrocarbon groups and two amino groups are bonded to tetravalent tin. Specifically, the diaminotin compound (3) has formula (3):

$$R_2Sn(NR'_2)_2 \qquad (3)$$

wherein R is a hydrocarbon group having 1 to 30 carbon atoms which is optionally substituted with a halogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.

Preferred specific examples of the substituents R and R' in diaminotin compound (3) are the same as those of R and R' in the triaminotin compound having formula (1).

The content of the diaminotin compound (3) in the present tin compound is preferably 0.5 mol% or less in terms of tin atoms, more preferably 0.1 mol% or less, particularly preferably 0.01 mol% or less, and most preferably 0 mol%. The preferred purity, particularly for stable storage, is 0.01 mol% or more, preferably 0.05 mol% or more, and even more preferably 0.1 mol% or more.

<Other Tin Compounds>

The present tin compound preferably contains a tin compound (7) represented by $RSn(NR')_2(N(R')CHNR'_2)$. A specific representative example is the following tin compound (7A).

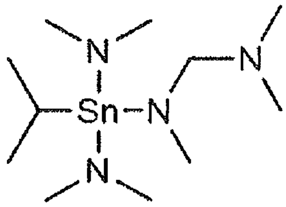

· · · · · (7 A)

In view of a high-purity resist material, the content of tin compound (7) is preferably 1.0 mol% or less in terms of tin atoms in the present tin compound, more preferably 0.5 mol% or less, even more preferably 0.1 mol% or less, and particularly preferably 0.01 mol% or less.

The present tin compound may contain a divalent tin compound (8) represented by $Sn(NR'_2)_2$. A specific example is $Sn(NMe_2)_2$ (8A).

In view of a high-purity and high-performance resist material, the present tin compound preferably does not contain tin compound (8). If tin compound (8) is present, the content of tin compound (8) is preferably 1.0 mol% or less in terms of tin atoms in the present tin compound, more preferably 0.5 mol% or less, even more preferably 0.1 mol% or less, and particularly preferably 0.01 mol% or less. The tin compound (1) is a tetravalent tin compound, whereas tin compound (8) is a divalent tin compound represented by $Sn(NR'_2)_2$. If a divalent tin compound is contained, a disproportionation or redox reaction may progress, which may promote decomposition of a tetravalent tin compound. Since divalent tin compound (8) has a small number of substituents and easily interacts with other tin compounds, divalent tin compound (8) may form impurities or insoluble matter in tin compound (1) by dimerization or oligomerization.

Further, the present tin compound may contain a tin compound (9) represented by $RSn(NR')_2(OR)$. A specific example is $iPrSn(NMe_2)_2(OiPr)$ (9A).

In view of a high-purity and high-performance resist material, the content of tin compound (9) is preferably 1.0 mol% or less in terms of tin atoms in the present tin compound, more preferably 0.5 mol% or less, even more preferably 0.1 mol% or less, and particularly preferably 0.01 mol% or less.

<Promoting Effect of Other Tin Compounds>

On the other hand, the inclusion of particular amounts of diaminotin compound (3), tin compound (7), and tin compound (9) in the present tin compound is preferred because their inclusion may promote the effect of the inclusion of the tetraaminotin compound (2) in the present tin compound. As used herein "promoting the effect of the inclusion of tetraaminotin compound (2)" may mean that the decomposition suppressing effect of tetraaminotin compound (2) is enhanced, that diaminotin compound (3), tin compound (7), and tin compound (9) each have a decomposition suppressing effect by the same mechanism as that of tetraaminotin compound (2), or may mean that diaminotin compound (3), tin compound (7), and tin compound (9) have a decomposition suppressing effect by a mechanism different from that of tetraaminotin compound (2). In particular, in terms of promoting this effect, it is preferable that diaminotin compound (3), tin compound (7), and tin compound (9) have a decomposition suppressing effect by a chemical structure or mechanism different from that of the tetraaminotin compound (2), because if so, the effect of suppressing decomposition derived from more diverse reactions and impurities can be exhibited. A specific promoting effect of tin compounds will be described below.

More specifically, in this case, the lower limit of the total amounts of tetraaminotin compound (2) and diaminotin compound (3) is preferably 0.001 mol% or more of the present tin compound, more preferably 0.01 mol% or more, even more preferably 0.05 mol% or more, and particularly preferably 0.1 mol% or more. The upper limit is preferably 3.0 mol% or less, more preferably 2.0 mol% or less, even more preferably 1.5 mol% or less, particularly preferably 1.0 mol% or less, and especially preferably 0.5 mol% or less.

The lower limit of the total amounts of tetraaminotin compound (2) and tin compound (7) is preferably 0.001 mol% or more of the present tin compound, more preferably 0.01 mol% or more, even more preferably 0.05 mol% or more, and particularly preferably 0.1 mol% or more. The upper limit is preferably 3.0 mol% or less, more preferably 2.0 mol% or less, even more preferably 1.5 mol% or less, particularly preferably 1.0 mol% or less, and especially preferably 0.5 mol% or less.

The lower limit of the total amount of tetraaminotin compound (2) and tin compound (9) is preferably 0.001 mol% or more of the present tin compound, more preferably 0.01 mol% or more, even more preferably 0.05 mol% or more, and particularly preferably 0.1 mol% or more. The upper limit is preferably 3.0 mol% or less, more preferably 2.0 mol% or less,

even more preferably 1.5 mol% or less, particularly preferably 1.0 mol% or less, and especially preferably 0.5 mol% or less.

Among these combinations of tin compounds, tetraaminotin compound (2) and tin compound (7), which are tin compounds having four $NR'_2$ structures, are more preferred, because they prevent decomposition such as disproportionation due to removal of the $NR'_2$ structure of triaminotin compound (1) and reactions between triaminotin compound (1) and other tin compounds, and have a high stabilizing effect. Unlike tetraaminotin compound (2), tin compound (7) has an $NR'_2$ structure bonded to a carbon atom (reacting more mildly than when bonded to a Sn atom). Therefore, this combination may suppress a wide range of decomposition reactions. Since tetraaminotin compound (2) and diaminotin compound (3) correspond to a decomposition product from a disproportionation reaction of triaminotin compound (1), it is preferable that particular amounts of tetraaminotin compound (2) and diaminotin compound (3) are included to suppress the disproportionation reaction. The diaminotin compound (3) is a dialkyl compound and has a decomposition suppressing effect different from that of tetraaminotin compound (2). In other words, since there are many alkyl groups that suppress interaction with other tin compounds and there are few $NR'_2$ structures with strong interaction, it may be possible to suppress formation of impurities or insoluble matter in triaminotin compound (1) by dimerization or oligomerization due to interaction with other tin compounds.

The tin compound (9) has an alkoxy substituent different from the $NR'_2$ structure of triaminotin compound (1) and tetraaminotin compound (2), and can suppress side reactions with alkoxy substituents (e.g., decomposition reaction by water and oxygen). In other words, the inclusion of both of tetraaminotin compound (2) and tin compound (9) can suppress a wider range of decomposition reactions.

The lower limit of the total amounts of tetraaminotin compound (2), diaminotin compound (3), tin compound (7), and tin compound (9) is 0.004 mol% or more of the present tin compound, more preferably 0.04 mol% or more, and even more preferably 0.2 mol% or more. The upper limit is preferably 3.0 mol% or less, more preferably 2.0 mol% or less, even more preferably 1.5 mol% or less, particularly preferably 1.0 mol% or less, and especially preferably 0.5 mol% or less.

More preferably, the present tin compound contains tetraaminotin compound (2), diaminotin compound (3), tin compound (7), and tin compound (9). In this case, the lower limit of the total amount of tetraaminotin compound (2), diaminotin compound (3), tin compound (7), and tin compound (9) is 0.003 mol% or more of the present tin compound, more preferably 0.03 mol% or more, and even more preferably 0.15 mol% or more. The upper limit is preferably 3.0 mol% or less, more preferably 2.0 mol% or less, even more preferably 1.5 mol% or less, particularly preferably 1.0 mol% or less, and especially preferably 0.5 mol% or less.

As described above, divalent tin compound (8) may promote the decomposition of triaminotin compound (1). However, coexistence of tin compound (8) with tetravalent tetraaminotin compound (2) which is more reactive than triaminotin compound (1) has the effect of suppressing the decomposition of triaminotin compound (1). When tin compound (8) and tetraaminotin compound (2) are used in combination, the lower limit of the total amount of tetraaminotin compound (2) and tin compound (8) is preferably 0.001 mol% or more of the present tin compound, more preferably 0.01 mol% or more, even more preferably 0.05 mol% or more, and particularly preferably 0.1 mol% or more. The upper limit is preferably 3.0 mol% or less, more preferably 2.0 mol% or less, even more preferably 1.5 mol% or less, particularly preferably 1.0 mol% or less, and especially preferably 0.5 mol% or less. In this combination of tetraaminotin compound (2) and tin compound (8), the content of tin compound (8) is preferably less than the content of tetraaminotin compound (2).

In addition, it is preferable to include a dialkyl compound of diaminotin compound (3) in addition to tetraaminotin compound (2) and tin compound (8), because if so, the effect of suppressing dimerization and oligomerization due to interaction with tin compounds such as tin compound (8) and further suppressing the decomposition of triaminotin compound (1) is high because of the promoting effect of the diaminotin compound (3) as described above. The lower limit of the total amount of tetraaminotin compound (2), diaminotin compound (3), and tin compound (8) is preferably 0.001 mol% or more of the present tin compound, more preferably 0.01 mol% or more, even more preferably 0.05 mol% or more, and particularly preferably 0.1 mol% or more. The upper limit is preferably 3.0 mol% or less, more preferably 2.0 mol% or less, even more preferably 1.5 mol% or less, particularly preferably 1.0 mol% or less, and especially preferably 0.5 mol% or less. In this combination of tetraaminotin compound (2), diaminotin compound (3), and tin compound (8), the content of tin compound (8) is preferably less than the total content of tetraaminotin compound (2) and diaminotin compound (3).

In addition, it is preferable to include tin compound (7) in addition to tetraaminotin compound (2) and tin compound (8), because if so, the effect of suppressing decomposition is higher because of the promoting effect of tin compound (7) described above. The lower limit of the total amount of tetraaminotin compound (2), tin compound (7), and tin compound (8) is preferably 0.001 mol% or more of the present tin compound, more preferably 0.01 mol% or more, even more preferably 0.05 mol% or more, and particularly preferably 0.1 mol% or more. The upper limit is preferably 3.0 mol% or less, more preferably 2.0 mol% or less, even more preferably 1.5 mol% or less, particularly preferably 1.0 mol% or less, and especially preferably 0.5 mol% or less. In this combination of tetraaminotin compound (2), tin compound (7), and tin compound (8), the content of tin compound (8) is preferably less than the total contents of tetraaminotin compound (2) and tin compound (7).

In addition, it is preferable to include tin compound (9) in addition to tetraaminotin compound (2) and tin compound (8), because if so, the effect of suppressing decomposition is higher because of the promoting effect of the

tin compound (9) described above. The lower limit of the total amount of tetraaminotin compound (2), tin compound (9), and tin compound (8) is preferably 0.001 mol% or more of the present tin compound, more preferably 0.01 mol% or more, even more preferably 0.05 mol% or more, and particularly preferably 0.1 mol% or more. The upper limit is preferably 3.0 mol% or less, more preferably 2.0 mol% or less, even more preferably 1.5 mol% or less, particularly preferably 1.0 mol% or less, and especially preferably 0.5 mol% or less. In this combination of tetraaminotin compound (2), tin compound (9), and tin compound (8), the content of tin compound (8) is preferably less than the total amount of tetraaminotin compound (2) and tin compound (9).

<Method for Producing Triaminotin Compound (1)>

A method for producing triaminotin compound (1), which is a target compound of the present disclosure, will now be described.

The triaminotin compound (1) may be synthesized by reacting a trihalohydrocarbyltin compound having formula (4) as a raw material with a lithium amide compound having formula (5).

$$RSnX_3 \qquad (4)$$

$$LiNR'_2 \qquad (5)$$

In formula (4), R is a hydrocarbon group having 1 to 30 carbon atoms which is optionally substituted with a halogen atom. In formula (5), R's are each a hydrocarbon group having 1 to 10 carbon atoms and may be identical or different from each other. Here, two R's on the same nitrogen atom may be bonded to each other to form a 3- to 7-membered ring containing nitrogen. In formula (4), X is a halogen atom.

Preferred specific examples of the substituent R in trihalohydrocarbyltin compound (4) and the substituent R' in lithium amide compound (5) are the same as those of R and R' in the triaminotin compounds having formula (1).

X represents a halogen atom, preferably a chlorine or bromine atom, and more preferably a chlorine atom.

The purity of trihalohydrocarbyltin compound (4) as a raw material is preferably higher, typically 95 mol% or more in terms of tin atoms, preferably 97 mol% or more, and even more preferably 99 mol% or more.

<<Present Tin Compound>>

The present tin compound will be described below with isopropyltris(dimethylamino)tin as a specific example of triaminotin compound (1).

For example, taking trichloroisopropyltin as an example, the raw material trihalohydrocarbyltin may be produced by chlorinating triphenylisopropyltin with hydrogen chloride gas or the like.

The resulting trichloroisopropyltin may be purified by distillation. Batch or continuous distillation can be used. In particular, batch distillation is preferred because a desired fraction can be recovered. When trichloroisopropyltin is purified by distillation, the temperature of the bottom of the distillation column is preferably 100°C or lower, more preferably 90°C or lower, and particularly preferably 80°C or lower, because if the temperature of the bottom of the distillation column is high, heat promotes degradation. The temperature of the top of the distillation column is preferably 40 to 70°C and the pressure at the top of the column is preferably 0.01 to 10 torr.

Isopropyltris(dimethylamino)tin may be produced by reacting the purified trichloroisopropyltin with dimethylaminolithium. In this reaction, it is known that a small amount of tetrakis(dimethylamino)tin and diisopropylbis(dimethylamino)tin are produced as byproducts.

Presumably, one molecule of tetrakis(dimethylamino)tin and one molecule of diisopropylbis(dimethylamino)tin are formed from two molecules of isopropyltris(dimethylamino)tin by a disproportionation reaction.

Tetrakis(dimethylamino)tin may also be formed by a reaction with lithium dimethylamide if the raw material trihaloisopropyltin contains tetrachlorotin.

The resulting isopropyltris(dimethylamino)tin may be purified by distillation.

Batch or continuous distillation can be used. In particular, batch distillation is preferred because a desired fraction can be recovered. When isopropyltris(dimethylamino)tin is purified by distillation, it is preferable to recover a distillate in the first half that contains tetrakis(dimethylamino)tin and contains less diisopropylbis(dimethylamino)tin. In distillation purification, the temperature of the bottom of the column is preferably 120°C or lower, more preferably 110°C or lower, and particularly preferably 100°C or lower, because if the temperature of the bottom of the column is high, heat promotes degradation. The temperature of the top of the column is preferably 40 to 110°C, and the pressure at the top of the column is preferably 0.1 to 20 torr.

The present tin compound can be obtained from the thus obtained isopropyltris(dimethylamino)tin accompanying a desired amount of tetrakis(dimethylamino)tin, by a method such as the following (A) or (B).

(A) Isopropyltris(dimethylamino)tin that does not contain tetrakis(dimethylamino)tin (at least below a detection limit) is prepared by optimizing the distillation method or by using a particular fraction in fractional distillation, and an appropriate amount of tetrakis(dimethylamino)tin is added to this isopropyltris(dimethylamino)tin to produce the present tin compound.

(B) Isopropyltris(dimethylamino)tin that contains an appropriate amount of tetrakis(dimethylamino)tin may be prepared by adjusting the distillation conditions or by using a particular fraction in fractional distillation (preferably a relatively first-half fraction, more preferably a first fraction).

For the purpose of adjusting a minute amount added, method (A) is preferred. Such a method is also preferred when other tin compounds such as tin compounds (3), (7), (8), and (9) are blended.

For the purpose of improving production efficiency, in method (B), the first fraction (low-boiling-point component) is intentionally included in a desired fraction to make a product.

As used herein "first fraction" refers to a fraction containing a low-boiling-point component that is distilled out prior to main distillation in fractional distillation, whereas a portion containing the desired purity of a target product is collected in the main distillation. The timing of switching between the first distillation and the main distillation may be determined by the temperature during distillation (temperature of the column top, internal temperature of the distillation unit), or may be distinguished by the purity of the resulting fractions. Specifically, in a case of distillation into two or more fractions, the first fraction refers to a fraction prior to the main distillation.

In the resulting present tin compound, the decomposition rate of triaminotin compound (1) after holding at 140°C for 5 hours under a nitrogen atmosphere is preferably 0.85 mol% or less, more preferably 0.8 mol% or less, and particularly preferably 0.7 mol% or less. The conditions of holding at 140°C for 5 hours under a nitrogen atmosphere correspond to the accelerated conditions of practical storage conditions (40°C or lower, under a nitrogen atmosphere). A low decomposition rate means excellent stability under practical storage conditions.

As a method for storing the present tin compound, the present tin compound is preferably stored in a container sealed under a nitrogen atmosphere, in particular, in a light-shielded and sealed container, and preferably in a light-shielded glass container (container wrapped with a light-shielding material, amber glass, etc.) or a stainless steel container. The period of storage is not limited, but storage for short to long periods of time, for example, from 3 days to 1 year is preferred. Storage for 5 years or even 10 years may be preferred if necessary. The upper limit of a storage temperature is preferably 40°C or lower, more preferably 30°C or lower, even more preferably 25°C or lower, and particularly preferably 20°C or lower. The lower limit of the temperature is preferably -10°C or higher.

The decomposition rate of triaminotin compound (1) may be calculated, for example, by the following formula.

Decomposition rate of triaminotin compound (1) (mol%) = "mol% of tin compound (1) at the time of preparation" - "mol% of tin compound (1) after holding at 140°C for 5 hours under nitrogen atmosphere" (Formula)

The resulting present tin compound can maintain high purity for a long time and thus can be a tin compound particularly suitable not only for storage in containers but also for stock and/or transportation.

The present tin compound may further contain a solvent if necessary. In order to facilitate application and deposition as a resist material, the present tin compound is preferably diluted with a solvent and used as a tin compound solution. The solvent is not limited and preferable examples include organic solvents such as alcohol, ether, ketone, amide, and ester solvents. Alcohol solvents are more preferred. These solvents may be used alone or in combination of two or more.

The alcohol solvents that may be used are, for example, aliphatic or alicyclic alcohols. Monohydric or polyhydric alcohols may be used, and polyhydric alcohol partial ether solvents can also be used. The carbon number is not limited and, for example, those having 2 to 18 carbon atoms can be used.

The solvent is preferably a solvent that does not itself contribute to metal contaminants.

The amount of solvent used is preferably 0.01 to 30 parts by mass, preferably 0.1 to 20 parts by mass, and particularly preferably 1 to 10 parts by mass, relative to 1 part by mass of the present tin compound.

The present tin compound may be subjected to a reaction such as hydrolysis to obtain a tin hydrolysate, which may be used as a resist material. As for its use as a resist material, for example, the method disclosed in JP-A-2021-21953 can be used. The present tin compound includes a group that can be hydrolyzed with water or other suitable reagents under appropriate conditions to form an alkyltin oxo-hydroxo patterning composition that can be represented by the formula $RSnO_{(1.5-(x/2))}(OH)_x$ (where x satisfies $0 < x \leq 3$). The hydrolysis and condensation reaction that can alter the composition by a hydrolysis group (X) is represented as follows.

$$RSnX_3 + 3H_2O \rightarrow RSn(OH)_3 + 3HX \cdot RSn(OH)_3 \rightarrow RSnO_{(1.5-(x/2))}OH_x + (x/2)H_2O$$

An alkyl oxohydroxytin (which may be referred to as "tin hydrolysate P1") composition having formula (10) that is obtained by hydrolyzing a composition containing the present tin compound as a raw material may be used as an EUV resist material. In other words, the hydrolyzed product of the present tin compound is the tin hydrolysate P1 having formula (10).

$$RSnO_{(3/2-X/2)}(OH)x \qquad (10)$$

wherein x satisfies $0 < x \leq 3$.

Examples of a compound included in the composition having formula (10) include mononuclear complexes such as RSnOOH and $RSn(OH)_3$, and dinuclear complexes such as $(RSn)_{12}O_{14}(OH)_6^{+2}$. The composition having formula (10) is preferably a composition containing a dinuclear complex (a complex in which two or more tin atoms exist in one molecule). More preferably, the alkyl oxohydroxytin composition (9) obtained by hydrolyzing the composition containing the present tin compound as a raw material does not contain a mononuclear complex.

The tin hydrolysate P1 composition is obtained by hydrolyzing the composition containing the present tin compound, and when the composition containing the present tin compound contains triaminotin compound (1) and tetraaminotin compound (2) defined in the present embodiment in a particular content ratio, tin hydrolysate P1 having high crystallinity, high purity, and uniform molecular weight can be obtained in high yield.

As used herein the yield is the yield (g) of tin hydrolysate P1 obtained when 3.4 mmol of the triaminotin compound (1) (3.4 mmol as tin atoms, 0.40 g) is used as a raw material. For example, when experiments are performed using the same raw material as described in Examples, the degree of the yield obtained in each experiment can be evaluated in relative terms. The preferred range of yield shown here is 0.10 g or more, more preferably 0.20 g or more, even more preferably 0.30 g or more, particularly preferably 0.40 g or more, and especially preferably 0.50 g or more in view of productivity and efficient thin film formation of the tin hydrolysate P1. The upper limit is preferably 1.00 g or less, more preferably 0.80 g or less, and even more preferably 0.70 g or less. If the yield exceeds the upper limit, the hydrolysis reaction is insufficient, or purification, washing or drying is insufficient, and the tin hydrolysate P1 may contain impurities or solvents. To improve the yield, it is effective to increase the crystallinity of the resulting tin hydrolysate P1 so that it is less soluble in solvents, or to optimize the type and amount of solvents used in the reaction and washing.

The present tin compound is the main component of the "composition containing the present tin compound" which is subject to hydrolysis, and typically contained in the composition in an amount of 50% by mass or more, preferably 55% by mass or more, more preferably 60% by mass or more, even more preferably 70% by mass or more, particularly preferably 80% by mass or more, especially preferably 90% by mass or more, and may be 100% by mass.

One of the methods for obtaining tin hydrolysate P1 by hydrolyzing the composition containing the present tin compound is, for example, a method in which a vapor generated by volatilizing the composition containing the present tin compound under heat or reduced pressure or a substrate on which the present tin compound is deposited is reacted with water vapor (dry method). In this method, a thin film (film) containing tin hydrolysate P1 can be formed on a substrate.

Another method for obtaining tin hydrolysate P1 is a method in which the composition containing the present tin compound in a solution or a solid state is reacted with water or the like and hydrolyzed. Subsequently, tin hydrolysate P1 may be dissolved in an organic solvent or the like and used as a coating solution.

The solution may be applied to a substrate by any coating or printing technique, so that a thin film (coating film) containing the tin hydrolysate P1 may be formed on the substrate.

The thin film obtained by any of the above methods may be stabilized or partially condensed prior to light irradiation through drying, heating, and the like. Thin films are generally thin and have an average thickness of, for example, less than 10 microns. Extremely thin submicron thin films, e.g., thin films of about 100 nm or less, 50 nm or less, and particularly 30 nm or less may be desirable in order to pattern extremely small features. The resulting thin film may be called "resist" because it is processed such that a portion of the composition is resistant to development/etching by exposure.

The thin film may be exposed to appropriate radiation, for example, extreme ultraviolet light, electron beam, or ultraviolet light, using a selected pattern or a negative portion of the pattern to form a latent image having a developer-resistant region and a developer-soluble region. After exposure to appropriate radiation and before development, the thin film may be heated or otherwise reacted so that the latent image is differentiated from a nonirradiated region. The latent image is brought into contact with a developer to form a physical image, that is, a patterned thin film. The patterned thin film may be further heated to stabilize the remaining thin film patterned on the surface. The patterned thin film may be used as a physical mask to perform further processing according to the pattern, for example, etching of the substrate and/or adhesion of additional materials. After the patterned resist is used as requested, the remaining patterned thin film may be removed at appropriate timing in processing, but the patterned thin film can be incorporated into a final structure.

EXAMPLES

The present disclosure will be described more specifically below with examples, but the present disclosure is not limited to the following examples without departing from the spirit of the present disclosure. In the examples, "part" and "%" are based on mass unless otherwise noted.

First, prior to the examples, isopropyltris(dimethylamino)tin was prepared.

The chemical shifts of $^{119}$Sn-NMR of isopropyltris(dimethylamino)tin after heating at 140°C for 5 hours under a nitrogen atmosphere and the amount of each compound are shown in Table 1 below.

Table 1

| | $Sn(NMe_2)_2$ | $(iPr)_2Sn(NMe_2)_2$ | Unknown* | $iPrSn(NMe_2)_3$ | Structural formula (7A) | Structural formula (9A) | $(NMe_2)_4Sn$ | Unknown* | Other impurities |
|---|---|---|---|---|---|---|---|---|---|
| $^{119}Sn$-NMR: chemical shift (ppm) | +120 | -18 | -38 | -64 | -82 | -105 | -120 | -155 | - |
| At the time of preparation (mol%) | ND | 0.29 | 0.17 | 98.90 | 0.50 | 0.14 | ND | ND | 0.00 |
| After heating at 140° C for 5 hours (mol%) | ND | 0.23 | 0.14 | 97.99 | 1.31 | ND | ND | 0.33 | 0.00 |

*Unknown: compound with unidentified structure

[Examples 1 to 2 and Comparative Examples 1 to 2]

Samples were prepared by adding tetrakis(dimethylamino)tin to the prepared isopropyltris(dimethylamino)tin [$^{119}$Sn-NMR purity: 98.90 mol%, diisopropylbis(dimethylamino)tin: 0.29 mol%, tin compound (7A): 0.50 mol%, tin compound (9A): 0.14 mol%, tetrakis(dimethylamino)tin: 0.01 mol% detection limit or less, bis(dimethylamino)tin: 0.01 mol% detection limit or less] to the content rates shown in Tables 2-1 and 2-2.

The compound (7A) is a tin compound having a chemical shift at - 82 ppm by $^{119}$Sn-NMR and has the following structural formula, and its structure was identified by $^{119}$Sn-NMR and $^{1}$H-NMR.

- $^{119}$Sn-NMR (223.8 MHz; $C_6D_6$): δ -82 ppm.
- $^{1}$H-NMR (600 MHz; $C_6D_6$): δ 3.37 (s, 2H, $CH_2$), 2.89 (s, 3H, Sn-NMe), 2.86 (s, 12H, Sn-$(NMe_2)_2$ ), 2.15 (s, 6H, $NMe_2$), 1.68 (m, 1H, iPr), 1.33 (s, 6H, iPr).

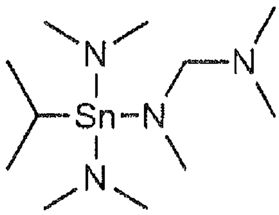

· · · · · (7 A)

The compound (9A) is a tin compound having a chemical shift at - 105 ppm by $^{119}$Sn-NMR and has the following structural formula, and its structure was identified by $^{119}$Sn-NMR and $^{1}$H-NMR.

$iPrSn(NMe_2)_2(OiPr)$

- $^{119}$Sn-NMR (223.8 MHz; $C_6D_6$): δ -105 ppm.
- $^{1}$H-NMR (400 MHz; $C_6D_6$): δ 4.1 (m, 1H OiPr), 2.7 (s, 12H $NMe_2$), 1.6 (m, 1H iPr), 1.2 (m, 12H (OiPr: 6H iPr: 6H)).

<Purity of Tin Compound>

The purity of isopropyltris(dimethylamino)tin at 0 hour in Examples 1 and 2, and Comparative Example 1 shown in Tables 2-1 and 2-2 below is calculated in consideration of the amount of tetrakis(dimethylamino)tin added, based on the purity of isopropyltris(dimethylamino)tin in Comparative Example 2 with no addition.

The prepared samples were each placed in a 5 mm diameter NMR tube and capped with a septa in a glove box under a nitrogen atmosphere, inserted into a 24 mm diameter test tube adapter filled with aluminum foil in a personal organic synthesizer ChemiStation PPM-5512, and held at a set temperature of 140°C for 5 hours under light-shielding conditions. Thereafter, $^{119}$Sn-NMR measurement was performed at 25°C. The results are shown in Tables 2-1 and 2-2.

Table 2-1

| | | Before heating | After heating at 140°C for 5 hours | |
|---|---|---|---|---|
| | $Sn(NMe_2)_4$ content rate (% by mass) | $iPrSn(NMe_2)_3$ (mol%) | $iPrSn(NMe_2)_3$ (mol%) | Decomposition rate (mol%) |
| Example 1 | 0.01% | 98.89 | 98.25 | 0.6 |
| Example 2 | 0.1% | 98.80 | 98.01 | 0.8 |
| Comparative Example 1 | 1% | 97.90 | 96.91 | 1.0 |
| Comparative Example 2 | Not added | 98.90 | 97.99 | 0.9 |

Table 2-2

| | | | $Sn(NMe_2)_2$ | $(iPr)_2Sn(NMe_2)_2$ | Unknown* | $iPrSn(NMe_2)_3$ | Structural formula (7A) | Structural formula (9A) | $(NMe_2)_4Sn$ | Unknown* | Other impurities |
|---|---|---|---|---|---|---|---|---|---|---|---|
| | $Sn(NMe_2)_4$ content rate (% by mass) | $^{119}Sn$-NMR: chemical shift (ppm) | +120 | -18 | -38 | -64 | -82 | -105 | -120 | -155 | - |
| Example 1 | 0.01% | At the time of preparation (mol%) | ND | 0.29 | 0.17 | 98.89 | 0.50 | 0.14 | 0.01 | ND | 0.00 |
| | | After heating at 140° C for 5 hours (mol%) | ND | 0.19 | 0.16 | 98.25 | 1.19 | ND | ND | 0.21 | 0.00 |
| Example 2 | 0.1% | At the time of preparation (mol%) | ND | 0.29 | 0.17 | 98.80 | 0.50 | 0.14 | 0.10 | ND | 0.00 |
| | | After heating at 140° C for 5 hours (mol%) | ND | 0.25 | 0.16 | 98.01 | 1.27 | ND | ND | 0.32 | 0.00 |
| Comparative Example 1 | 1% | At the time of preparation (mol%) | ND | 0.29 | 0.17 | 97.90 | 0.50 | 0.14 | 1.00 | ND | 0.00 |
| | | After heating at 140° C for 5 hours (mol%) | ND | 0.27 | 0.15 | 96.91 | 1.26 | ND | 1.11 | 0.31 | 0.00 |

(continued)

| | | | $Sn(NMe_2)_2$ | $(iPr)_2Sn(NMe_2)_2$ | Unknown* | $iPrSn(NMe_2)_3$ | Structural formula (7A) | Structural formula (9A) | $(NMe_2)_4Sn$ | Unknown* | Other impurities |
|---|---|---|---|---|---|---|---|---|---|---|---|
| | $Sn(NMe_2)_4$ content rate (% by mass) | $^{119}Sn$-NMR: chemical shift (ppm) | +120 | -18 | -38 | -64 | -82 | -105 | -120 | -155 | - |
| Comparative Example 2 | Not added | At the time of preparation (mol%) | ND | 0.29 | 0.17 | 98.90 | 0.50 | 0.14 | ND | ND | 0.00 |
| | | After heating at 140° C for 5 hours (mol%) | ND | 0.23 | 0.14 | 97.99 | 1.31 | ND | ND | 0.33 | 0.00 |

*Unknown: compound with unidentified structure

Tables 2-1 and 2-2 demonstrate that compared with the decomposition rate of triaminotin compound (1) in Comparative Example 2 in which no tetraaminotin compound (2) was added, both Examples 1 and 2 containing a particular trace amount of tetraaminotin compound (2) had excellent thermal stability since thermal decomposition of the triaminotin compound (1) was suppressed even under severe conditions (accelerated conditions of practical storage conditions) such as heating at 140°C for 5 hours.
This suggests that a resist material prepared by using each of the example tin compounds obtained by Examples 1 and 2 and adding 6 parts of methanol to 1 part of the tin compound maintains high purity of the triaminotin compound (1).
In Table 2-2, the $Sn(NMe_2)_4$ content (% by mass) means that $Sn(NMe_2)_4$ was added in an amount of the percentage mass listed in Table 2-2 to the mass of the sample used. Here, the molecular weight of $Sn(NMe_2)_4$ is 294.7 and the molecular weight of $iPrSn(NMe_2)_3$ is 293.7, so "% by mass" and "mol%" can be considered equivalent.
The difference in decomposition rate between Example 2 and Comparative Example 2 appears to be a slight difference but is thought to be a significant difference in stability during practical storage (e.g., storage for 1 year) when long-term stock is considered. In addition, for use as a resist for semiconductor manufacturing, the highest possible purity is desirable in order to draw fine patterns.

[Comparative Example 3]

The following tin compound including isopropyltris(dimethylamino)tin as a main component was prepared.

- Isopropyltris(dimethylamino)tin: 84.28 mol%
- Diisopropylbis(dimethylamino)tin: 13.16 mol%
- Tetrakis(dimethylamino)tin: 0.00 mol% (0.01 mol% detection limit)
- Compound of structural formula (7A): 1.94 mol%
- Total of other impurities: 0.62 mol%

The above tin compound was placed in an amount of 62.04 g in a 100 mL four-necked flask. A packed distillation tube from Kiriyama Glass Works Co. (KIRIYAMA Pac FR64-4-A: 5 theoretical stages, 100 mm long, 16 mm inside diameter) was attached. Distillation was carried out at an oil bath temperature of 119°C and a pressure of 0.7 kPa, and two fractions, namely, 16.6 g of a first fraction and 19.3 g of a second fraction, were taken in turn. The remainder is residue in the flask.
Each fraction was measured by $^{119}Sn$-NMR and had the composition shown in Table 3 below.
The tetraaminotin compound (2) was formed in the distillate by a disproportionation reaction upon heating during distillation at 119°C. The tetraaminotin compound (2) was detected only in the first fraction because its boiling point is lower than that of the target product.
About 1 g of each of the two fractions was placed in a 5 mm diameter NMR tube and capped with a septum, and inserted into a 24 mm diameter test tube adapter filled with aluminum foil in a personal organic synthesizer ChemiStation PPM-5512, held at a set temperature of 140°C for 5 hours under light-shielding conditions, and then returned to room temperature (23°C). Then $^{119}Sn$-NMR was measured. The results are shown in Table 3 below.

Table 3

| | $Sn(NMe_2)_2$ | $(iPr)_2Sn(NMe_2)_2$ | Unknown* | $iPrSn(NMe_2)_3$ | Structural formula (7A) | Structural formula (9A) | $(NMe_2)_4Sn$ | Unknown* | Other impurities |
|---|---|---|---|---|---|---|---|---|---|
| $^{119}Sn$-NMR: chemical shift (ppm) | +120 | -18 | -38 | -64 | -82 | -105 | -120 | -155 | - |
| First fraction (mol%) | ND | 9.91 | 0.14 | 88.82 | 0.11 | 0.38 | 0.36 | ND | 0.29 |
| Second fraction (mol%) | ND | 11.78 | 0.07 | 87.28 | 0.12 | 0.39 | ND | ND | 0.36 |
| Comparative Example 3-1: after heating first fraction (mol%) | 3.50 | 12.34 | ND | 79.28 | 4.20 | ND | 0.37 | 0.14 | 0.17 |
| Comparative Example 3-2: after heating second fraction (mol%) | 15.59 | 19.43 | ND | 57.75 | 6.52 | ND | ND | ND | 0.71 |

*Unknown: compound with unidentified structure

As the result, the decomposition rate of isopropyltris(dimethylamino)tin after heating of each fraction is as follows.

[Comparative Example 3-1] First fraction: 9.54 mol%
[Comparative Example 3-2] Second fraction: 29.53 mol%

In Comparative Example 3-1, the tin compound containing triaminotin compound (1) with a purity of 88.82 mol% and 0.36 mol% of tetraaminotin compound (2) had a decomposition rate of 9.54 mol%, which was larger than in Examples 1 and 2. In Comparative Example 3-2, the tin compound containing triaminotin compound (1) with a purity of 87.28 mol% and containing no tetraaminotin compound (2) had an even greater decomposition rate of 29.53 mol%.

[Example 4]

A tin compound 4-1 including isopropyltris(dimethylamino)tin as a main component as shown in Table 4 below was prepared. A heating test was carried out using the tin compound 4-1 at 140°C for 5 hours in the same manner as in Example 1. The result is shown in Table 4 below. The tin compound had a decomposition rate of 0.8% and had excellent thermal stability.

The tin compound 4-1 was produced by the following method. A reactor (200 L glass reactor) and a stirring device (impeller: TWINSTIR, diameter: 350 mm, width: 110 mm) were used for the reaction. The reactor was purged with nitrogen three times under reduced pressure. Special-grade hexane (36.6 kg, moisture content 30 ppm) and n-butyl lithium (41.0 kg, 96.8 mol, 15% hexane solution, 3.09 eq.) were added, and dimethylamine (8.69 kg, 193.6 mol, 6.18 eq.) was added dropwise under stirring at 150 rpm while keeping between -5 and 10°C.

The resulting slurry of dimethyl lithium amide was stirred at 23 to 27°C for 5 hours. The temperature of the resulting slurry of dimethylamide was adjusted to 0°C. A hexane solution (4.20 kg) of isopropyltrichlorotin (8.40 kg, 31.3 mol, 1.00 eq, purity greater than 99.9 mol%) was added dropwise at a constant rate from a glass dropper over 3 hours while maintaining an internal temperature of 0 to 10°C. After adding dropwise, the temperature was raised to 20 to 25°C and, with this temperature kept, the mixture was stirred for 16 hours. The resulting reaction solution was filtered through a pressure filter to remove a white solid (LiCl) to obtain a transparent filtrate. The white solid was further washed with dehydrated hexane (7.3 kg $\times$ 3), and the filtrates were combined.

After the resulting reaction solution was concentrated under reduced pressure, 9.3 kg of crude tin compound containing isopropyltris(dimethylamido)tin was obtained. The resulting crude tin compound was distilled under reduced pressure and heating (glass simple distillation device wrapped with light-shielding cloth, internal temperature: 70 to 80°C, degree of decompression: 0.3 kPa) to obtain 6.1 kg of the corresponding tin compound 4-1 as a fraction. The resulting tin compound was introduced into a sealed container (brown glass bottle) under a nitrogen atmosphere and stored under light-shielding conditions.

[Comparative Example 4]

A tin compound was prepared by adding tetrakis(dimethylamino)tin equivalent to 10 mol% to the tin compound 4-1 to obtain a tin compound 4-2. A heating test was carried out using the tin compound 4-2 at 140°C for 5 hours in the same manner as in Example 4. The result is shown in Table 4 below.

[Production of Tin Hydrolysate]

Hydrolysis was performed using these tin compounds 4-1 and 4-2 to obtain the corresponding tin hydrolysates 4-1 and 4-2. The synthesis method, yields, and analytical results for the tin hydrolysates 4-1 and 4-2 are shown below.

To a 100 mL flask under an inert gas atmosphere, 10 mL of n-hexane (dehydrated) and 1.0 g (3.4 mmol) of the tin compound 4-1 were added in turn and dissolved under stirring at 150 rpm. After cooling the resulting solution to 0 to 10°C, demineralized water (1.0 mL, resistance 18.2 M$\Omega$) was added by a syringe over 10 minutes under stirring at 150 rpm at a temperature kept at 0 to 10°C to form a suspension. The resulting suspension was filtered through KIRIYAMA ROHTO (filter paper 5B) to obtain a white solid. The resulting white solid was washed with 3 mL of demineralized water and then vacuum-dried at 40°C for 8 hours. The resulting white solid was obtained as tin hydrolysate 4-1. The yield after drying of the tin hydrolysate 4-1 was 0.55 g and that of the tin hydrolysate 4-2 was 0.41 g.

The tin hydrolysates 4-1 and 4-2 were identified by NMR and both samples showed 1:1 peaks in SnNMR (MeOD): 5-coordinated ($iPrSnO_4$): -337 ppm and 6-coordinated (iPrSnOs): -513 ppm. This correlates with the NMR result for the tin dodecamer cluster $(nBuSn)_{12}O_{14}(OH)_6$ as reported in Organometallics 19, 2000, 1940-1949. In other words, a compound corresponding to i-$PrSnO_{(3/2-x/2)}(OH)x$ was obtained.

Analysis by electrospray ionization mass spectrometry (ESI-MS) was performed. As shown in FIG. 1, only peaks corresponding to divalent ion ($[(iPrSn)_{12}O_{14}(OH)_6]^{+2}$, calculated m/z=1134), and monovalent ion (m/z=2268), and their

adducts such as potassium (corresponding to m/z+40) corresponding to i-$PrSnO_{(3/2-x/2)}$ were observed from the tin hydrolysate 4-1.

As shown in FIG. 2, a peak corresponding to a higher polymer was observed from the tin hydrolysate 4-2 in addition to the peak corresponding to the tin hydrolysate 4-1, and a shift of the peak distribution toward the higher molecular weight was observed.

When comparing tin hydrolysates 4-1 and 4-2, the half width (full-width at half-maximum) at the peak with the highest intensity (peak top diffraction angle 7 to 9°) in XRD (FIG. 3 and FIG. 4) was 1.4° for the tin hydrolysate 4-1 and 1.8° for the tin hydrolysate 4-2. The results are shown in Table 4 below. In other words, tin hydrolysate 4-1 showed a smaller full-width at half-maximum and higher crystallinity.

In summary, tin compound 4-1 of Example 4 yielded tin hydrolysate 4-1 with high yield, high crystallinity, high purity, and uniform molecular weight. In other words, it can be understood that a resist material with higher purity and higher performance was obtained in Example 4, compared with Comparative Example 4.

Table 4

| | $Sn(NMe_2)_2$ | $(iPr)_2Sn(NMe_2)_2$ | Unknown* | $iPrSn(NMe_2)_3$ | Structural formula (7A) | Structural formula (9A) | $(NMe_2)_4Sn$ | Unknown* | Other impurities | Hydrolysate | |
|---|---|---|---|---|---|---|---|---|---|---|---|
| $^{119}$Sn-NMR: chemical shift (ppm) | +120 | -18 | -38 | -64 | -82 | -105 | -120 | -155 | - | Yield (g) | XRD FWHM |
| Example 4 (tin compound 4-1) | ND | 0.24 | ND | 99.20 | 0.49 | 0.03 | 0.04 | ND | 0.00 | 0.55 | 1.4 |
| **Example** 4 (after 140°C 5h heating test) | 0.15 | 0.24 | 0.02 | 98.41 | 1.06 | ND | 0.09 | 0.03 | 0.00 | - | |
| Comparative Example 4 (tin compound 4-2) | Add 10% of $Sn(NMe_2)_4$ to Example 4 | | | | | | | | | 0.41 | 1.8 |

*Unknown: compound with unidentified structure

[Example 5]

The obtained tin hydrolysate 4-1 of Example 4 was dissolved in 4-methyl-2-pentanol (5 mL) to a concentration of 2.0% while using ultrasound, and the resulting solution was filtered through a 0.45 μm syringe filter to obtain a transparent resist solution containing tin hydrolysate. A silicon wafer with an oxide surface (Si substrate, 100 mm diameter) was ozone-treated and used as a substrate for adhesion of a resist thin film (film). The surface of the Si substrate was treated with hexamethyldisilazane (HMDS) vapor prior to resist adhesion. The resist solution was spin-coated onto the substrate at 2000 rpm and baked on a hot plate at 90°C for 2 minutes. The film thickness after coating and baking was 22 nm as measured by an ellipsometer. The coated substrate was exposed to ultraviolet light [light source: xenon excimer lamp (172 nm, 7.2 eV) from Ushio Inc., light source intensity: 0.7 $mW/cm^2$] using a pattern, and the pattern is projected onto the substrate. The substrate was then immersed in 2-heptanone for 15 seconds and rinsed with the same developer for another 15 seconds to form a negative image, that is, an image in which the non-exposed portion of the thin film (film) was removed and only the pattern-exposed portion was left.

Although specific forms in the present disclosure have been described in the examples, the examples are merely illustrative and should not be construed as limiting. It is contemplated that various modifications evident to those skilled in the art could be made without departing from the scope of the present disclosure.

INDUSTRIAL APPLICABILITY

The tin compound containing a triaminotin compound according to the present disclosure has excellent thermal stability because of the inclusion of a particular trace amount of tetraaminotin compound, can maintain high purity of the triaminotin compound for a long time, and can be highly promising as a photoresist material.

## Claims

1. A tin compound comprising 95 mol% or more of a triaminotin compound having formula (1) in terms of tin atoms, and 0.001 to 0.5 mol% of a tetraaminotin compound having formula (2) in terms of tin atoms:

$$RSn(NR'_2)_3 \qquad (1)$$

$$Sn(NR'_2)_4 \qquad (2)$$

wherein in formula (1) and (2), R is a hydrocarbon group having 1 to 30 carbon atoms which is optionally substituted with a halogen, an oxygen atom, or a nitrogen atom, and R’s are each a hydrocarbon group having 1 to 10 carbon atoms and may be identical or different from each other, and
wherein two R’s on the same nitrogen atom may be bonded to each other to form a 3- to 7-membered ring containing nitrogen.

2. The tin compound according to claim 1, wherein the tin compound comprises 97 mol% or more of the triaminotin compound having formula (1) in terms of tin atoms.

3. The tin compound according to claim 1 or 2, wherein the tin compound comprises 0.5 mol% or less of a diaminotin compound having formula (3) in terms of tin atoms:

$$R_2Sn(NR'_2)_2 \qquad (3)$$

wherein in formula (3), R is a hydrocarbon group having 1 to 30 carbon atoms and optionally substituted with halogen, an oxygen atom, or a nitrogen atom, and R’s are each a hydrocarbon group having 1 to 10 carbon atoms and may be identical or different from each other, and
wherein two R’s on the same nitrogen atom may be bonded to each other to form a 3- to 7-membered ring containing nitrogen.

4. The tin compound according to any one of claims 1 to 3, wherein the tin compound comprises 0.01 to 0.5 mol% of the

tetraaminotin compound having formula (2) in terms of tin atoms.

5. A tin compound comprising 95 mol% or more of a triaminotin compound having formula (1) in terms of tin atoms, wherein the triaminotin compound having formula (1) has a decomposition rate of 0.85 mol% or less after being held at 140°C for 5 hours under a nitrogen atmosphere:

$RSn(NR'_2)_3$ (1)

wherein in formula (1), R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, and
wherein two R's on the same nitrogen atom may be bonded to each other to form a 3- to 7-membered ring containing nitrogen.

6. The tin compound according to claim 5, wherein the tin compound comprises 97 to 99.9 mol% of the triaminotin compound having formula (1) in terms of tin atoms.

7. The tin compound according to any one of claims 1 to 6, wherein the tin compound further comprises 0.001 to 1.0 mol% of a compound having formula (7) in terms of tin atoms:

$RSn(NR')_2(N(R')CHNR'_2)$ (7)

wherein in formula (7), R is a hydrocarbon group having 1 to 30 carbon atoms and optionally substituted with halogen, an oxygen atom, or a nitrogen atom, and R's are each a hydrocarbon group having 1 to 10 carbon atoms and may be identical or different from each other, and
wherein two R's on the same nitrogen atom may be bonded to each other to form a 3- to 7-membered ring containing nitrogen.

8. The tin compound according to claim 7, wherein the tin compound comprises 0.001 mol% or more of each of the compounds having formula (2) and formula (7), and a total content of the compounds having formula (2) and formula (7) is 0.001 to 1.0 mol% in terms of tin atoms.

9. The tin compound according to any one of claims 1 to 8, wherein the tin compound further comprises 0.001 to 1.0 mol% of a compound having formula (9) in terms of tin atoms:

$RSn(NR')_2(OR)$ (9)

wherein in formula (9), R is a hydrocarbon group having 1 to 30 carbon atoms and optionally substituted with halogen, an oxygen atom, or a nitrogen atom, and R's are each a hydrocarbon group having 1 to 10 carbon atoms and may be identical or different from each other, and
wherein two R's on the same nitrogen atom may be bonded to each other to form a 3- to 7-membered ring containing nitrogen.

10. A tin compound comprising 95 mol% or more of a triaminotin compound having formula (1) in terms of tin atoms, 0.001 to 0.5 mol% of a tetraaminotin compound having formula (2) in terms of tin atoms, 0.5 mol% or less of a diaminotin compound having formula (3) in terms of tin atoms, 0.001 to 1.0 mol% of a compound having formula (7) in terms of tin atoms, and 0.001 to 1.0 mol% of a compound having formula (9) in terms of tin atoms:

$RSn(NR'_2)_3$ (1)

$Sn(NR'_2)_4$ (2)

$R_2Sn(NR'_2)_2$ (3)

$RSn(NR')_2(N(R')CHNR'_2)$ (7)

$RSn(NR')_2(OR)$ (9)

wherein

in formula (1) and (2), R is a hydrocarbon group having 1 to 30 carbon atoms which is optionally substituted with a halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen;
in formula (3), R is a hydrocarbon group having 1 to 30 carbon atoms and optionally substituted with halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen;
in formula (7), R is a hydrocarbon group having 1 to 30 carbon atoms and optionally substituted with halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen; and
in formula (9), R is a hydrocarbon group having 1 to 30 carbon atoms and optionally substituted with halogen, an oxygen atom, or a nitrogen atom, and R's are each a hydrocarbon group having 1 to 10 carbon atoms and may be identical or different from each other, wherein two R's on the same nitrogen atom may be bonded to each other to form a 3- to 7-membered ring containing nitrogen.

**11.** The tin compound according to any one of claims 1 to 10, wherein the tin compound further comprises a solvent.

**12.** A method for storing a tin compound, wherein the tin compound according to any one of claims 1 to 11 is stored in a sealed container under a nitrogen atmosphere.

**13.** The method for storing a tin compound according to claim 12, wherein the tin compound is stored for a period of 3 days to 1 year.

**14.** The method for storing a tin compound according to claim 12 or 13, wherein the tin compound is stored at a temperature of -10°C or higher and 40°C or lower.

**15.** A method for producing a tin compound according to any one of claims 1 to 10 is obtained, the method comprising a step of obtaining a target tin compound as a fraction by distilling a crude tin compound.

**16.** A method for producing a tin compound according to any one of claims 1 to 10 is obtained, the method comprising a step of obtaining a target tin compound by adding the tetraaminotin compound having formula (2) to a tin compound that contains the triaminotin compound having formula (1) but does not contain the tetraaminotin compound having formula (2).

**17.** The method for producing a tin compound according to claim 15 or 16, wherein a first fraction is included in a fraction in distillation of a crude tin compound.

**18.** A tin hydrolysate of the tin compound according to any one of claims 1 to 11, wherein the tin hydrolysate has formula (10):

$RSnO_{(3/2-x/2)}(OH)_x$ (10)

wherein x satisfies $0 < x \leq 3$.

**19.** A tin hydrolysate solution comprising the tin hydrolysate according to claim 18 and an organic solvent.

**20.** A tin hydrolysate thin film comprising the tin hydrolysate according to claim 18.

FIG. 1

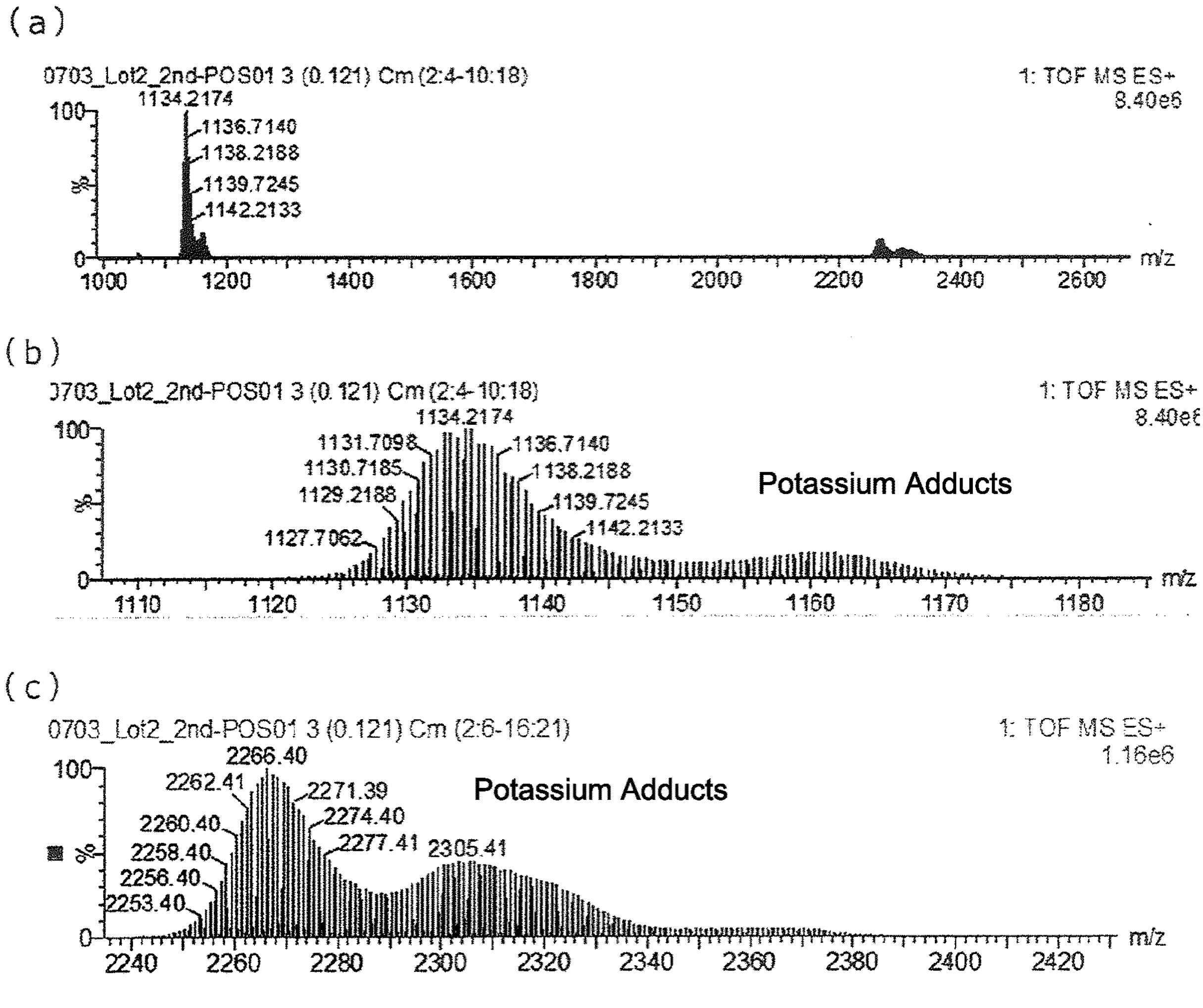
(a)
0703_Lot2_2nd-POS01 3 (0.121) Cm (2:4-10:18)
1: TOF MS ES+
8.40e6
1134.2174
1136.7140
1138.2188
1139.7245
1142.2133
100
%
0
1000
1200
1400
1600
1800
2000
2200
2400
2600
m/z
(b)
0703_Lot2_2nd-POS01 3 (0.121) Cm (2:4-10:18)
1: TOF MS ES+
8.40e6
1134.2174
1131.7098
1130.7185
1129.2188
1127.7062
1136.7140
1138.2188
1139.7245
1142.2133
Potassium Adducts
100
%
0
1110
1120
1130
1140
1150
1160
1170
1180
m/z
(c)
0703_Lot2_2nd-POS01 3 (0.121) Cm (2:6-16:21)
1: TOF MS ES+
1.16e6
2266.40
2262.41
2260.40
2258.40
2256.40
2253.40
2271.39
2274.40
2277.41
2305.41
Potassium Adducts
100
%
0
2240
2260
2280
2300
2320
2340
2360
2380
2400
2420
m/z

FIG. 2

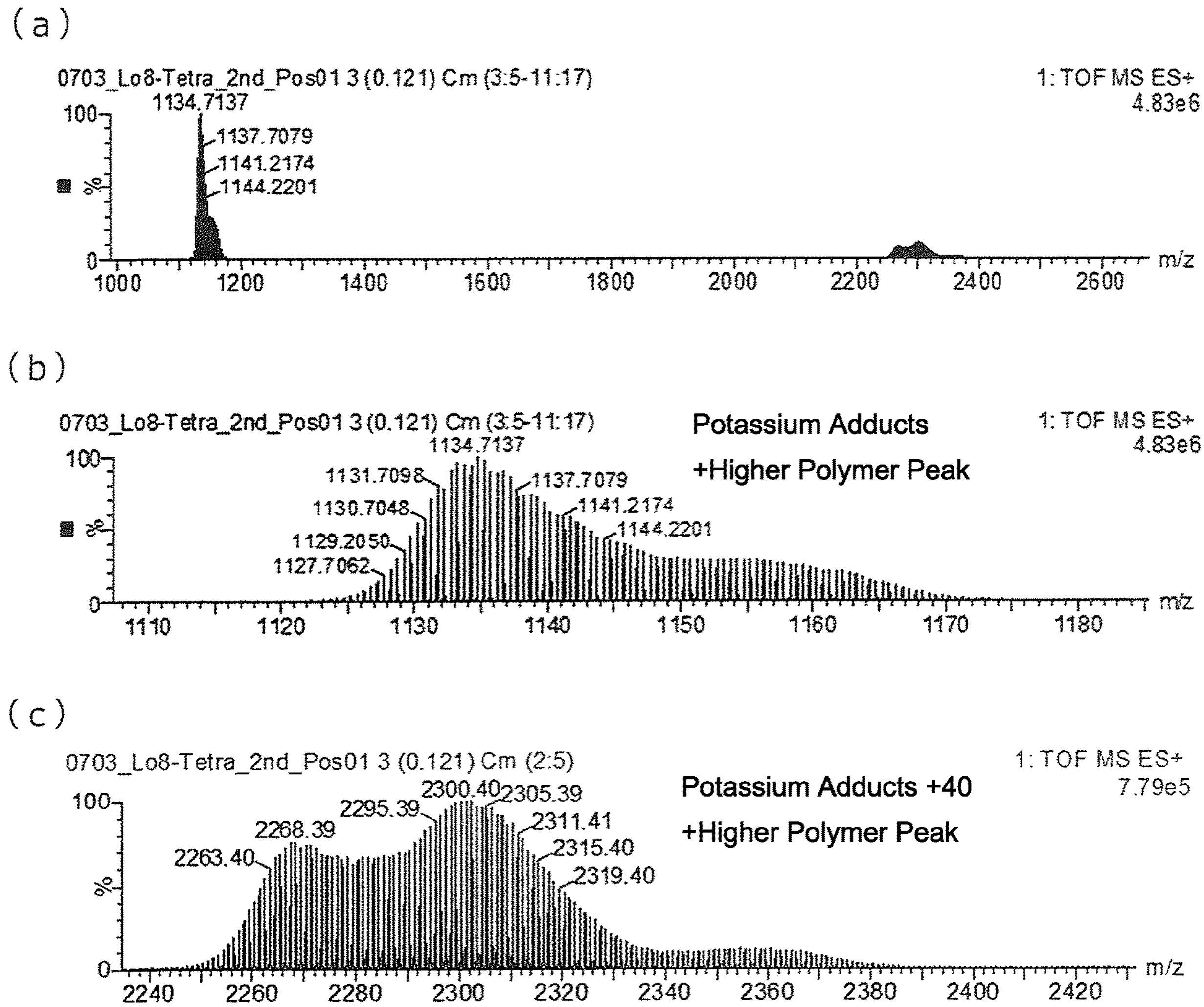
(a)
0703_Lo8-Tetra_2nd_Pos01 3 (0.121) Cm (3:5-11:17)
1: TOF MS ES+
4.83e6
1134.7137
1137.7079
1141.2174
1144.2201
%
m/z
(b)
0703_Lo8-Tetra_2nd_Pos01 3 (0.121) Cm (3:5-11:17)
Potassium Adducts
+Higher Polymer Peak
1: TOF MS ES+
4.83e6
1134.7137
1131.7098
1137.7079
1130.7048
1141.2174
1129.2050
1144.2201
1127.7062
%
m/z
(c)
0703_Lo8-Tetra_2nd_Pos01 3 (0.121) Cm (2:5)
1: TOF MS ES+
7.79e5
Potassium Adducts +40
+Higher Polymer Peak
2300.40
2305.39
2295.39
2311.41
2268.39
2315.40
2263.40
2319.40
%
m/z

FIG. 3

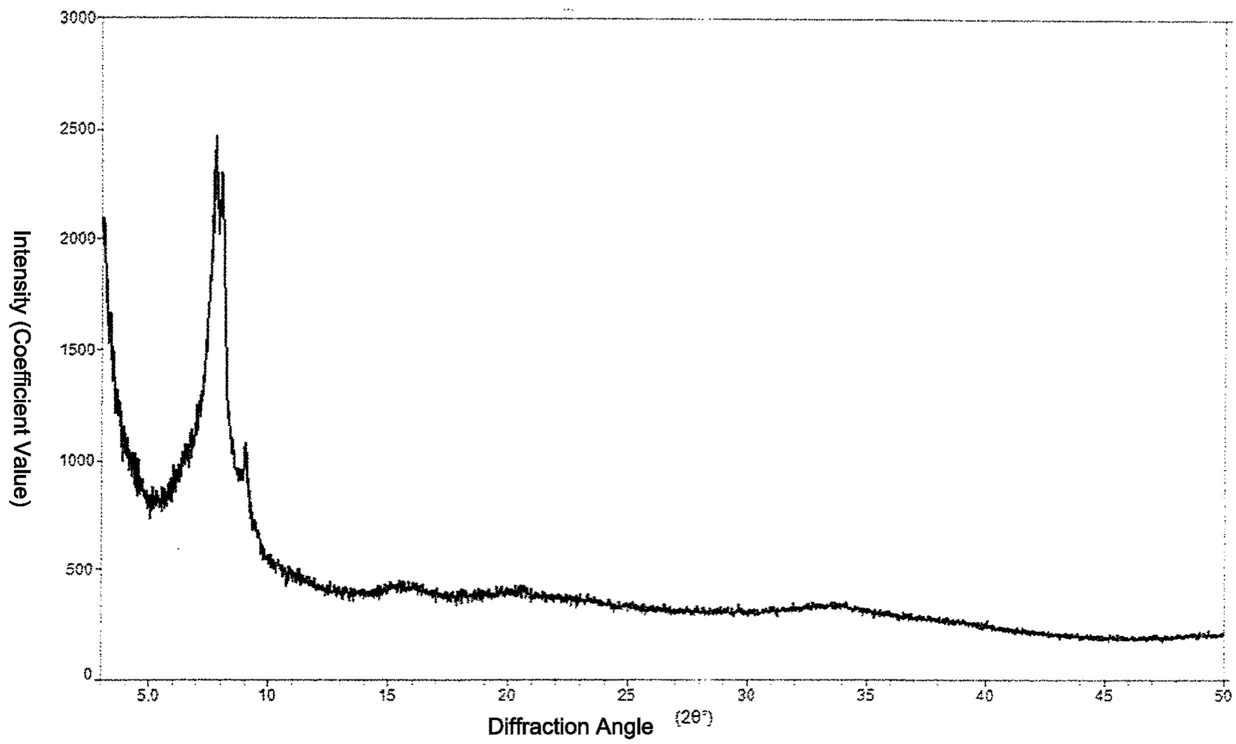
Intensity (Coefficient Value)
3000
2500
2000
1500
1000
500
0
5.0
10
15
20
25
30
35
40
45
50
Diffraction Angle (2θ°)

FIG. 4

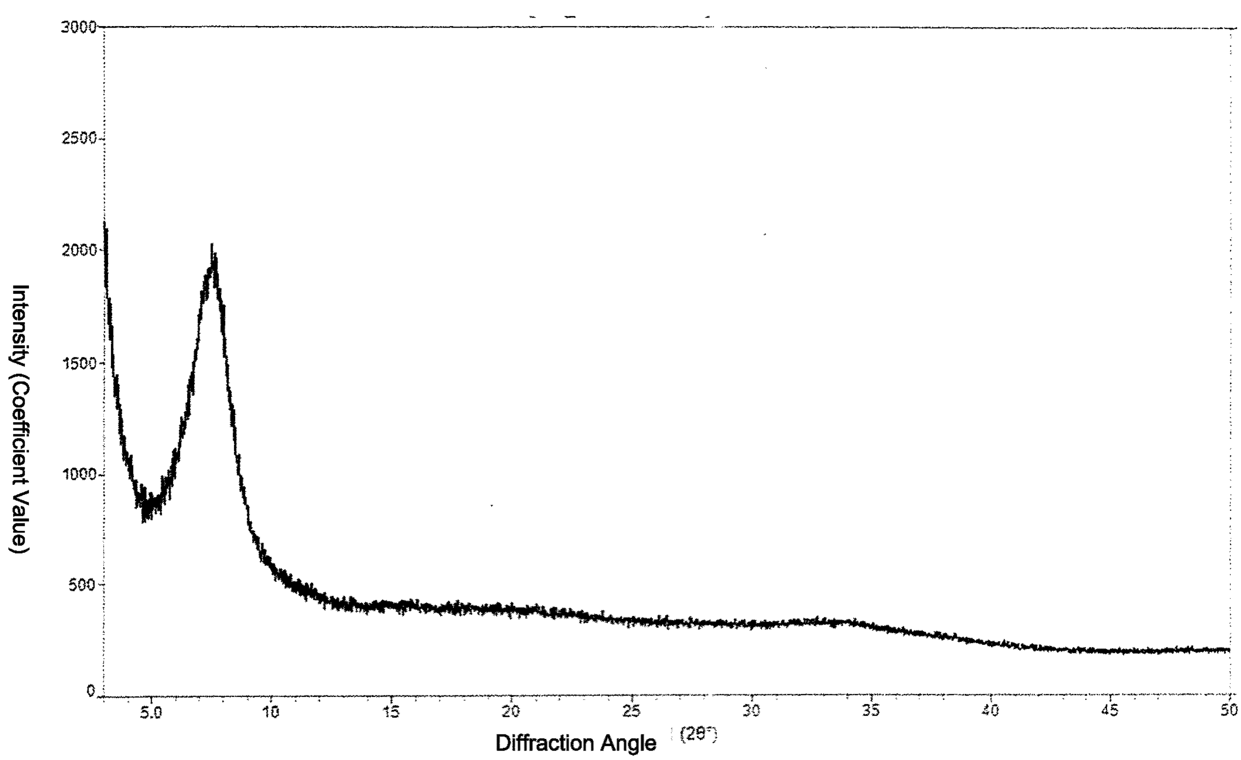
3000
2500
2000
1500
1000
500
0
Intensity (Coefficient Value)
5.0
10
15
20
25
30
35
40
45
50
Diffraction Angle (2θ°)

## INTERNATIONAL SEARCH REPORT

International application No.
**PCT/JP2024/007675**

**A. CLASSIFICATION OF SUBJECT MATTER**

***C07F 7/22***(2006.01)i; ***C01G 19/00***(2006.01)i; ***G03F 7/004***(2006.01)i
FI: C07F7/22 M CSP; C01G19/00 Z; C07F7/22 G; G03F7/004; G03F7/004 531

According to International Patent Classification (IPC) or to both national classification and IPC

**B. FIELDS SEARCHED**

Minimum documentation searched (classification system followed by classification symbols)

C07F7/22; C01G19/00; G03F7/004

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | JP 2021-519340 A (INPRIA CORPORATION) 10 August 2021 (2021-08-10) table 1, examples, paragraphs [0013]-[0018] | 1-6, 11-15, 17-20 |
| A | table 1, examples, paragraphs [0013]-[0018] | 7-10, 16 |
| X | WO 2022/165381 A1 (ENTEGRIS, INC.) 04 August 2022 (2022-08-04) examples A-L, paragraph [0004] | 1-15, 17-20 |
| A | examples A-L, paragraph [0004] | 16 |
| A | JP 2021-528536 A (INPRIA CORPORATION) 21 October 2021 (2021-10-21) paragraphs [0014], [0015] | 1-20 |
| P, X | WO 2023/235534 A1 (GELEST, INC.) 07 December 2023 (2023-12-07) claims, examples | 1-15, 17-20 |
| P, A | claims, examples | 16 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 May 2024** | **21 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/007675**

| Patent document cited in search report | Publication date (day/month/year) | Patent family member(s) | Publication date (day/month/year) |
| --- | --- | --- | --- |
| JP 2021-519340 A | 10 August 2021 | US 2019/0315781 A1<br>paragraph [0054], tables, examples, paragraphs [0029]-[0033]<br>US 2019/0315782 A1<br>US 2021/0024552 A1<br>US 2021/0198293 A1<br>US 2020/0369691 A1<br>WO 2019/199467 A1<br>TW 201943725 A<br>KR 10-2020-0058572 A<br>CA 3080934 A<br>CN 112088335 A<br>KR 10-2021-0068152 A<br>KR 10-2021-0068153 A<br>TW 202214665 A<br>KR 10-2023-0107905 A<br>KR 10-2023-0109781 A<br>TW 202317593 A<br>CA 3219374 A | |
| WO 2022/165381 A1 | 04 August 2022 | JP 2024-504731 A<br>US 2023/0295196 A1<br>US 2022/0242888 A1<br>EP 4284808 A1<br>KR 10-2023-0132582 A<br>CN 116897158 A<br>TW 202246293 A | |
| JP 2021-528536 A | 21 October 2021 | US 2019/0391486 A1<br>paragraphs [0014], [0015]<br>US 2022/0187705 A1<br>WO 2019/246254 A1<br>TW 202000679 A<br>KR 10-2020-0139264 A<br>TW 202206440 A<br>KR 10-2023-0034431 A<br>TW 202334172 A | |
| WO 2023/235534 A1 | 07 December 2023 | US 2023/0391804 A1 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020122959 A
- WO 2022165381 A
- JP 2021021953 A


### Non-patent literature cited in the description


- *Organometallics*, 2000, vol. 19, 1940-1949